# EUROPÄISCHE PATENTSCHRIFT

(11) **EP 2 277 242 B1**
(45) Veröffentlichungstag und Bekanntmachung des Hinweises auf die Patenterteilung: **07.09.2011**
(21) Anmeldenummer: 09741951.9
(22) Anmeldetag: 02.04.2009
(51) Int. Cl.: H01R 24/60, H05K 3/30, H05K 3/36, H05K 7/14

(54) **MESSERLEISTEN-KONTAKTIERUNG ÜBER ZWISCHENLEITERPLATTEN**
CONTACTING OF MULTIPOINT CONNECTORS BY MEANS OF INTERMEDIATE CIRCUIT BOARDS
MISE EN CONTACT DE RÉGLETTES DE CONTACTS À COUTEAUX PAR LE BIAIS DE CARTES DE CIRCUIT IMPRIMÉ INTERMÉDIAIRES

(30) Priorität: 05.05.2008 DE 102008001557
(43) Veröffentlichungstag der Anmeldung: 26.01.2011
(73) Patentinhaber: Robert Bosch GmbH, 70442 Stuttgart (DE)
(72) Erfinder: SEIBOLD, Jochen, 72070 Tuebingen (DE); ECKERT, Bernd, 71665 Vaihingen An Der Enz (DE)
(86) Internationale Anmeldenummer: PCT/EP2009/053913
(87) Internationale Veröffentlichungsnummer: WO 2009/135733

(56) Entgegenhaltungen:
- US-A- 4 907 978
- US-A1- 2005 085 103
- US-A1- 2006 118 330

## Beschreibung

### Stand der Technik

Die Erfindung geht aus von einem Steckverbindersystem, insbesondere von einem Messerleisten-Verbindungssystem, wie es beispielsweise für Motor-Steuergeräte in Kraftfahrzeugen verwendet wird.

Steckverbinder werden zur elektrischen Verbindung von elektrischen Komponenten verwendet, die als einzelne Module vorgesehen sind, wobei die Steckverbinder zum Anschluss von Verbindungskabeln dienen. Bei einer Vielzahl von Kontakten sind diese als Leiste mit einer oder mit mehreren Reihen angeordnet. Somit kann eine elektrische Verbindung mittels Pins vorgesehen werden, die in einer Leiterplatte eingesteckt sind und mit dieser elektrisch verbunden sind.

Die Druckschrift DE 42 44 626 A1 zeigt eine Steckverbindung zwischen zwei Leiterplatten, die senkrecht zueinander angeordnet sind. Eine der Leiterplatten umfasst eine Kontaktierungseinrichtung, in die mittels Führungselementen die andere Leiterplatte senkrecht eingesteckt wird. Die Druckschrift zeigt somit eine gewinkelte Steckerleistenverbindung.

Die Druckschrift US 2005/0085103 A1 offenbart zwei Leiterplatten, die zueinander senkrecht angewinkelt sind, wobei ein Zwischenelement als Winkelblock dient und beide Elemente mechanisch miteinander verbindet. Innerhalb des Winkelblocks sind flexible, gebogene Leitungen dargestellt, die die elektrische Verbindung zwischen den beiden Leiterplatten vorsehen. Die dargestellte Kontaktierung basiert somit auf flexiblen, gebogenen Leitungen.

Die Druckschrift DE 10 2006 005 045 A1 zeigt eine Steckverbindungsvorrichtung, die ein doppelwandiges Bauteil trägt, wobei das doppelwandige Bauteil einen Hohlraum aufweist, in dem Kontakte vorgesehen sind, die über Bohrungen erreichbar sind. Die Bohrungen sind zum Einstecken eines Steckerkörpers vorgesehen, der eine Gruppe von Pins trägt. Die dargestellte Vorrichtung ist somit mit einer einzelnen Leiterplatte ausgestattet, die einen Hohlkörper trägt, in dem alle elektrischen Kontaktelemente des Bauteils vorgesehen sind.

Für viele Anwendungsbereiche ist es vorteilhaft, einen horizontalen Steckerabgang verwenden zu können, wodurch das aufwändige Herstellen und Abbiegen von Kontaktpins entfällt. Bei geraden Pins bzw. Stiften wird zur Fortführung der elektrischen Verbindung in einer anderen Ebene eine flexible Verbindung benötigt, beispielsweise eine teilflexible "Semi-flex"-Leiterplatte. Die Fortführung der elektrischen Verbindung in einer anderen Ebene ist oftmals durch die Anwendung bestimmt und ist auf Grund von Halterungen, anderen Modulen oder auf Grund von Platzmangel notwendig.

Eine derartige flexible Zwischenverbindung ist jedoch kostspielig und bedarf komplexer Verarbeitungsschritte, die den Aufwand weiter steigern.

Es ist daher eine Aufgabe der Erfindung, ein derartiges Steckverbindungssystem vorzusehen, das kostengünstiger und mit geringerem Aufwand hergestellt werden kann.

### Offenbarung der Erfindung

Die Erfindung erlaubt eine kostengünstigere und einfachere elektrische Verbindung für Steckleistensysteme. Insbesondere ist die Herstellung vereinfacht, da alle Elemente aus gleichen Grundelementen, d. h. Leiterplatten, hergestellt werden können, wobei die Verbindungstechnik durch bereits bekannte Lötverfahren realisiert werden kann. Zudem ermöglicht die Erfindung eine einfache Verbindung durch Einstecken in Schlitze, beispielsweise in einen oder in mehrere Schlitze einer Hauptleiterplatte. Die Erfindung kann mit kostengünstigen Materialien vorgesehen werden, insbesondere kann die erfindungsgemäße Steckverbindung ohne kostspielige flexible Leiterplatten oder ähnliche Leiter umgesetzt werden. Die erfindungsgemäße Zwischenleiterplatte, die an die Stelle der flexiblen Verbindung tritt, kann neben der elektrischen Verbindung auch Schaltungen vorsehen, beispielsweise indem die Zwischenleiterplatte mit elektrischen Bauelementen bestückt wird. Im Gegensatz zu Stecksystemen mit flexiblen Verbindungen, die keine elektrischen Bauelemente direkt tragen können, wird es so beispielsweise möglich, dass elektrische Bauelemente, die einen EMV-Filter bilden, näher an einer Steckverbinderleiste angeordnet sind. Dadurch lässt sich insbesondere bei hochfrequenten Signalen eine bessere Filterwirkung erzielen. Während im Stand der Technik die flexiblen Verbindungselemente nur zu einer Verschlechterung der elektromagnetischen Verträglichkeit beigetragen haben, ist es mit der erfindungsgemäßen Steckerleistenverbindung möglich, dass die dort verwendete Zwischenleiterplatte im Gegensatz hierzu Filtereigenschaften aufweist bzw. Filter-Baukomponenten, die die elektromagnetische Verträglichkeit deutlich erhöhen.

Die in der erfindungsgemäßen Steckerleistenverbindung verwendete Zwischenleiterplatte kann, im Gegensatz zu den im Stand der Technik verwendeten flexiblen Verbindungselementen, eine weitere Funktion erfüllen, d. h. das Tragen der Pins bzw. von Einzel-Steckverbindungselementen, die eine Steckverbinderleiste bilden. Ferner ermöglicht die Erfindung eine einfache und kostengünstige Montage von Einzel-Steckverbindungselementen in die Zwischenleiterplatte, um die Einzel-Steckverbindungselemente mechanisch miteinander zu verbinden. Die Einzel-Steckverbindungen können in die Zwischenleiterplatte durch Einpressen eingebracht werden, oder können mit dieser verlötet werden, Dadurch lassen sich bekannte kostengünstige Verbindungsmechanismen verwenden, im Gegensatz zu flexiblen Verbindern wie einer flexiblen Leiterplatte, bei denen sich die Einzel-Steckverbindung nur mit bestimmten, aufwändigen Verbindungstechniken verbinden lassen.

Das der Erfindung zu Grunde liegende Konzept liegt darin, eine Zwischenleiterplatte zum Versetzen von Verbindungsebenen zu verwenden, d. h. zur Verbindung einer Steckverbinderleiste mit einer Hauptleiterplatte, die vorzugsweise parallel zur Steckverbinderleiste verläuft. Zur Verbindung wird die Zwischenleiterplatte gewinkelt zu der Hauptleiterplatte und gewinkelt zu den Steckverbindungselementen der Steckverbinderleiste angeordnet und mit diesen beispielsweise verlötet, über eine Steckverbindung verbunden, oder eine Kombination hiervon. Die Erstreckungsrichtung der einzelnen Steckverbinderelemente, insbesondere die Erstreckungsrichtung von Steckverbindungs-Stiften, wird somit versetzt von der Hauptleiterplatte fortgeführt, wobei die Versetzung durch die Zwischenleiterplatte vorgesehen wird. Um zu erreichen, dass sich die Steckverbindungselemente parallel zur dazu versetzten Hauptleiterplatter erstrecken, ist die Zwischenleiterplatte sowohl zu den Steckverbindungselementen als auch zu der Hauptleiterplatte vorzugsweise mit dem gleichen Winkel abgewinkelt, beispielsweise um 90°. Die Hauptleiterplatte wird somit zu den sich längs erstreckenden Steckverbindungselementen in eine Richtung versetzt, die in einer Normalebene der Erstreckungsrichtung der Steckverbindungselemente liegt. Vorzugsweise ist die Versetzungsrichtung senkrecht zur Erstreckungsrichtung der Steckverbindungselemente und senkrecht zu der Richtung, in die sich die Steckverbinderleiste erstreckt.

Die Längserstreckungsrichtung der Steckverbinderleiste, die Quererstreckung der Hauptleiterplatte und die Quererstreckung der Zwischenleiterplatte sind vorzugsweise parallel zueinander. Im Querschnitt bildet so die erfindungsgemäße Steckerleistenverbindung vorzugsweise eine Treppenform, wobei die Steckverbindungselemente senkrecht zu der sich daran anschließenden Zwischenleiterplatte sind, und die Zwischenleiterplatte wiederum senkrecht zu der sich daran anschließenden Hauptleiterplatte. Die Steckverbindungselemente weisen zumindest Abschnitte auf, die sich in eine erste Richtung erstrecken, wobei sich die Hauptleiterplatte zumindest teilweise von der Zwischenleiterplatte in eine zweite Richtung erstreckt, die senkrecht zu der ersten Richtung ist.

Um eine elektrische Verbindung zwischen den Steckverbindungselementen und der Hauptleiterplatte vorzusehen, umfasst die Zwischenleiterplatte vorzugsweise mindestens eine und vorzugsweise zwei Außenlagen, die als Leiterschichten vorgesehen sind. Beide Außenlagen lassen sich ohne Weiteres durch bekannte Maßnahmen (beispielsweise Fotolithographie) strukturieren, so dass beliebige Einzelverbindungen zwischen Steckverbindungselementen und Hauptleiterplatte vorgesehen werden können. Ebenso umfasst die Hauptleiterplatte mindestens eine und vorzugsweise zwei Außenlagen, die ebenso als Leiterschicht vorgesehen sind, und die einen Kontaktanschluss für die darauf stoßende Zwischenleiterplatte realisiert. Die Außenlage(n) kann/können auch Lötpads oder andere Kontaktelemente zum Abschluss von elektrischen Bauelementen, beispielsweise Filterkomponeten u. Ä. umfassen.

Die Steckverbindungselemente sind vorzugsweise Einzel-Steckverbindungselemente und haben eine langgestreckte Form. Je nach Einsatz sind die Steckverbindungselemente Stifte oder als Buchsen ausgebildet und in die Zwischenleiterplatte eingepresst, teilweise eingesteckt, mit dieser verlötet oder eine Kombination hiervon. Hierzu umfasst die Zwischenleiterplatte vorzugsweise Ausnehmungen, beispielsweise Durchgangslöcher, in die die einzelnen Steckverbindungselemente eingesteckt sind, wobei jedes Steckverbindungselement vorzugsweise einen nur diesem Steckverbindungselement zugeordneten Kontakt aufweist, der auf der Zwischenleiterplatte vorgesehen ist und nur mit dem zugehörigen Steckverbindungselement verbunden ist. Gleichzeitig wird dieser Kontakt durch die Zwischenleiterplatte fortgeführt und erreicht die Hauptleiterplatte über eine weitere elektrische Verbindung zwischen der Hauptleiterplatte und der Zwischenleiterplatte. Die Einzel-Steckverbindungen sind somit eineindeutig einem Kontakt oder einer Leiterbahn oder einem Kontaktpad der Leiterplatte zugeordnet.

Neben der elektrischen Verbindung sieht die Steckverbinderleiste eine mechanische Stabilisierung oder Anordnung der Steckverbindungselemente vor, so dass diese gruppiert vorgesehen werden können. Vorzugsweise entspricht die Gruppierung der Einzel-Steckverbindungselemente einer Reihe oder mehreren parallelen Reihen mit gleicher Länge, wobei die Einzel-Steckverbindungselemente in einem vorbestimmten Raster und vorzugsweise gleichmäßig voneinander beabstandet sind und in einer Linie oder zueinander parallelen Linien in die Zwischenleiterplatte eingesteckt sind. Die Gruppierung kann auch in mehrere Untergruppen erfolgen, wobei beispielsweise eine erste Untergruppe eine periodische lineare Anordnung mit geringem Abstand mit dünnen Steckverbindungselementen vorsieht, und eine weitere Untergruppe mit dicken bzw. dickeren Steckverbindungselementen vorgesehen ist, die in einem größeren Abstand zueinander angeordnet sind. Die dünneren Steckverbindungselemente bzw. die entsprechende Untergruppe können/kann einer Parallelschnittstelle für Signale, beispielsweise Steuersignalen, zugeordnet sein, wobei die dickeren Verbindungselemente mit größerem Abstand bzw. die entsprechende Untergruppe einem Leistungsanschluss, beispielsweise einer Endstufe, entsprechen/entspricht. Die Zwischenleiterplatte kann verschiedene Untergruppen gleicher oder unterschiedlicher Funktion tragen.

Die Zwischenleiterplatte ist vorzugsweise mit Verbindungselementen ausgestattet, die mittels einer Leiterschicht oder mittels mehrerer Leiterschichten vorgesehen werden. Verbindungselemente dienen zum einen zum direkten elektrischen Kontakt mit der Hauptleiterplatte, zum anderen zum direkten elektrischen Kontakt mit den Steckverbindungselementen sowie zur elektrischen Verbindung der Steckverbindungselemente mit Leitern auf der Hauptleiterplatte. Zudem kann die Zwischenleiterplatte weitere Verbindungselemente aufweisen, beispielsweise Kontaktpads, Lötverbindungen und/oder elektrisch verbindende Steckverbindungen, die vorzugsweise zwischen der Steckverbinderleiste und der Hauptleiterplatte vorgesehen sind, wobei diese Verbindungselemente zum Anschluss von elektrischen elektronischen Bauelementen vorgesehen sind, die sich auf mindestens einer der Oberflächen der Zwischenleiterplatte befinden. Somit können elektrische oder elektronische Bauteile auf die Zwischenleiterplatte aufgebracht werden und mit dieser verbunden werden, beispielsweise durch SMD-Technik, durch Durchstecktechnik oder durch andere Techniken, wobei die Bauteile vorzugsweise SMD-Bauteile sind, die über Kontaktpads mit der Zwischenleiterplatte verbunden sind. Die Bauteile können aktive oder passive Bauteile sein, insbesondere eignen sich Filterbauelemente, daher Kondensatoren oder Induktivitäten, vorzugsweise SMD-Kondensatoren mit kleiner Bauweise und hoher relativer Dielektrizitätskonstante. Ferner können die Bauelemente kleinere Baugruppen sein, die einen elektronischen Filter vorsehen.

Zur mechanischen Verbindung der Zwischenleiterplatte mit der Hauptleiterplatte können diese miteinander verlötet werden, wobei dies gleichzeitig eine elektrische Verbindung darstellt. Vorzugsweise umfasst die Hauptleiterplatte Schlitze, in die die Zwischenleiterplatte bzw. ein Ende der Zwischenleiterplatte eingesteckt wird, wodurch sich eine weitere mechanische Stabilisierung ergibt. Die Schlitze bzw. die Enden der Zwischenleiterplatte können derart ausgestaltet sein und komplementäre elektrische Kontakte aufweisen, dass sich durch das Einstecken in die Schlitze ebenso ein elektrischer Kontakt ergibt. Zur Vereinfachung der Montage und zur stabilen Befestigung der Zwischenleiterplatte mit der Hauptleiterplatte kann die Zwischenleiterplatte (oder die Hauptleiterplatte) mit Rastelementen ausgestattet sein, die die Steckverbindung, welche durch die Schlitze in der Hauptleiterplatte und durch ein Ende der Zwischenleiterplatte vorgesehen wird, zu stabilisieren. Die Hauptleiterplatte kann einen Schlitz oder kann mehrere Schlitze umfassen, wobei die Zwischenleiterplatte vorzugsweise an einem Ende entsprechende komplementäre Gegenstücke umfasst, die beim Einstecken mit den Schlitzen (bzw. Einstecken in den Schlitz) der Hauptleiterplatte einen Presssitz erzeugen. Die elektrischen Verbindungselemente zwischen Zwischenleiterplatte und Hauptleiterplatte sind vorzugsweise auf der Seite der Zwischenleiterplatte an einem Rand bzw. an einem Ende der Zwischenleiterplatte vorgesehen. Vorzugsweise sind Kontakte an diesem Ende der Zwischenleiterplatte vorgesehen, um die elektrische Verbindung zu der Hauptleiterplatte vorzusehen.

Wenn die Zwischenleiterplatte Bauelemente trägt, beispielsweise elektronische Bauelemente, die als EMV-Filter arbeiten, dann können Kontakte der Steckverbinderleiste über diese Bauelemente mit Leiterbahnen verbunden sein, die sich an einem Rand der Zwischenleiterplatte befinden, wobei sich der Rand von der Steckverbinderleiste zu der Hauptleiterplatte erstreckt. Ebenso kann sich dieser Rand entlang der Steckverbinderleiste und entlang der Hauptleiterplatte erstrecken, d. h. an der Kontaktstelle zwischen Hauptleiterplatte und Zwischenleiterplatte. An der Verbindungsstelle zwischen Zwischenleiterplatte und Hauptleiterplatte sind vorzugsweise Pads oder Leiterbahnenterminals vorgesehen, die über Lötverbindungen miteinander verbunden werden. Vorzugsweise wird das Montieren und das elektrische Kontaktieren der auf die Hauptleiterplatte treffenden Zwischenleiterplatte und der Hauptleiterplatte selbst durch bekannte Verbindungstechniken zwischen "daughter-boards" und "mother-boards" vorgesehen. Es können bekannte Verbindungstechniken verwendet werden, mit denen sich zueinander gewinkelte Leiterplatten miteinander verbinden lassen.

Die Zwischenleiterplatte kann einteilig oder mehrteilig sein, d. h. in Segmente aufgeteilt sein, wobei sich jedes Segment zwischen der Hauptleiterplatte und der Steckverbinderleiste erstreckt und die Segmente untereinander in Längserstreckungsrichtung der Steckverbinderleiste getrennt sind. Dies erlaubt die Verringerung mechanischer Spannungen, die beispielsweise durch unterschiedliche thermische Ausdehnungskoeffizienten hervorgerufen werden.

Die Steckverbindungselemente bilden gruppiert vorzugsweise eine Messerleiste, eine Federleiste, eine Stiftleiste oder eine Pfostensteckerleiste. Je nach Ausführung der Steckverbindungselemente (male/female) kann die Leiste als Steckerleiste, Buchsenleiste oder Verbinderleiste ausgeführt sein. Die Steckverbindungselemente sind als Stifte oder Pins ausgeführt und weisen im Falle von Buchsenleisten einen Abschnitt auf, der ein Aufnahmeelement in Form einer Buchse umfasst, an den sich ein Stiftabschnitt zur Montage in Durchgangslöchern, beispielsweise Bohrungen einer Leiterplatte anschließt. Die Steckverbindungselemente können die Form von Drahtabschnitten aufweisen, vorzugsweise mit konstantem Querschnitt, wobei der Drahtdurchmesser dem Zweck und insbesondere der Stromfestigkeit angepasst ist.

Zur Befestigung können neben Rastelementen auch Führungselemente oder Anschläge vorgesehen sein, die einzeln oder als Kombination auf der Leiterplatte, auf der Zwischenleiterplatte oder auf beiden Leiterplatten angeordnet sind bzw. mechanisch an diesen befestigt sind.

In einer bevorzugten Ausführungsform sind die Einzel-Steckverbindungen, die als Gruppe die Steckverbinderleiste bilden, über einen Stecker oder Buchsenkörper miteinander verbunden, der die Steckverbindungselemente mechanisch miteinander verbindet, jedoch elektrisch voneinander isoliert. Der Steckerkörper (oder Buchsenkörper) umfasst vorzugsweise umspritztes Isolationsmaterial, das die Einzel-Steckverbindungselemente umgibt oder in die die Steckverbindungselemente eingeschossen sind. Die Steckverbindungselemente können gleichermaßen in die Zwischenleiterplatte eingeschossen oder eingepresst werden. Als weiteres Beispiel kann der Steckerkörper (oder Buchsenkörper) auf die Steckverbinderleiste und somit auf die Steckverbindungselemente aufgesteckt werden. Der Steckerkörper (oder Buchsenkörper) kann kragenförmig ausgebildet sein und/oder durch ein Kunststoffgehäuse vorgesehen sein, das mit der Steckverbinderleiste mechanisch verbunden ist. Die Steckerleistenverbindung kann ferner ein Kunststoffgehäuse umfassen, das einen Steckerkragen bzw. einen Steckerkörper ausbildet, wobei der Steckerkragen bzw. Steckerkörper Isolationsmaterial umfasst, das die Steckverbindungselemente der Steckverbinderleiste miteinander mechanisch verbindet. Vorzugsweise wird die mechanische Verbindung vorgesehen, indem ein vorgefertigtes Isolationsmaterial, das einen Steckerkragen und/oder einen Steckerkörper bildet, einteilig mit einem Kunststoffgehäuse ausgebildet ist, und dieses auf die Steckverbindungselemente der Steckverbinderleiste geschoben wird.

Die Einzel-Steckverbindungselemente der Steckverbinderleiste werden vorzugsweise in die Zwischenleiterplatte eingepresst, die entsprechende Ausnehmungen umfasst, wobei die Steckverbindungselemente ebenso auf bzw. in die Zwischenleiterplatte eingelötet werden können oder in die Zwischenleiterplatte einzeln eingepresst werden, vorzugsweise mit einem Single-Pin-Insertion-Verfahren.

Das der Erfindung zu Grunde liegende Konzept wird ferner durch ein erfindungsgemäßes Verfahren umgesetzt, das vorsieht, die Einzel-Steckverbindungselemente als Steckverbinderleiste anzuordnen, beispielsweise über ein wieder entfernbares Werkzeug oder durch Einführen in einen Steckerkörper. Ferner umfasst das Verfahren das Befestigen der Steckverbinderleiste an der Zwischenleiterplatte, wobei die Einzel-Steckverbindungselemente, die die Steckverbinderleiste bilden, gewinkelt und vorzugsweise senkrecht an die Zwischenleiterplatte montiert werden bzw. in diese eingerührt werden. Durch das Einführen der Steckverbindungselemente wird vorzugsweise ein Presssitz mit der Zwischenleiterplatte hervorgerufen. Ferner umfasst das Verfahren das Erstellen elektrischer Kontakte zwischen der Zwischenleiterplatte und der Steckverbinderleiste, wobei dies umfasst: Das Einführen der Steckverbindungselemente in die Zwischenleiterplatte, Löten der Steckverbindungselemente an Kontakte der Zwischenleiterplatte (beispielsweise Pads) oder eine Kombination hiervon. Das Verfahren sieht ferner vor, die Zwischenleiterplatte an der Hauptleiterplatte zu befestigen, vorzugsweise durch Einstecken, durch Verlöten eines Rands bzw. eines Endes der Zwischenleiterplatte mit entsprechenden Kontakten bzw. Kontaktfeldern der Hauptleiterplatte oder gegebenenfalls durch Einstecken der Zwischenleiterplatte in ein Steckelement, das mit der Hauptleiterplatte verbunden ist. Durch das Befestigen der Zwischenleiterplatte an der Hauptleiterplatte wird vorzugsweise bereits ein elektrischer Kontakt hergestellt, wobei der elektrische Kontakt auch durch Lötverbindungen zwischen Hauptleiterplatte und Zwischenleiterplatte vorgesehen werden kann.

Das Erstellen elektrischer Kontakte, insbesondere zwischen der Hauptleiterplatte und der Zwischenleiterplatte, wird vorgesehen durch Einstecken oder Verlöten von Kontaktflächen, die auf der Zwischenleiterplatte und der Hauptleiterplatte vorgesehen sind. Die Kontaktflächen werden vorzugsweise durch Leiterschichten der Hauptleiterplatte bzw. der Zwischenleiterplatte gebildet. Hierzu umfassen die Zwischenleiterplatte und/oder die Hauptleiterplatte mindestens eine Leiterschicht, die strukturiert ist, um Leiterbahnen und Kontaktflächen auszubilden. Diese werden vorzugsweise durch Löten elektrisch miteinander verbunden. Das Befestigen der Zwischenleiterplatte an der Hauptleiterplatte kann vorgesehen werden, indem die Leiterplatte in einen Schlitz in der Hauptleiterplatte eingesteckt wird. Dadurch ergibt sich eine mechanische, elektrische oder elektromechanische Verbindung zwischen Zwischenleiterplatte und Hauptleiterplatte.

Das Verfahren sieht ferner vorzugsweise vor, Einzel-Steckverbindungselemente der Steckverbinderleiste durch Umspritzen mit einem Isolationsmaterial mechanisch miteinander zu verbinden, oder die mechanische Verbindung vorzusehen, indem die Steckverbindungselemente in einen Körper, vorzugsweise aus Isolationsmaterial, eingeschossen werden oder Isolationsmaterial auf die Steckverbinderleiste aufgesteckt oder aufgeschoben wird. Das Isolationsmaterial kann einen vorgefertigten Körper bilden, der vorzugsweise einen Steckerkragen und/oder einen Steckerkörper bildet, beispielsweise einen Wannenstecker. Das Isolationsmaterial kann einteilig oder mehrteilig ausgeformt sein.

Die Hauptleiterlatte, die Zwischenleiterplatte oder beide Leiterplatten sind vorzugsweise steife Leiterplatten, beispielsweise Epoxid-Leiterplatten oder Hartpapier-Leiterplatten. Die Leiterplatten sind vorzugsweise eben und können einseitig oder doppelseitig mit einer Kupferkaschierung ausgebildet sein.

### Kurze Beschreibung der Zeichnungen

Ausführungsbeispiele der Erfindung sind in den Zeichnungen dargestellt und in der nachfolgenden Beschreibung näher erläutert.

Es zeigen
- Figur 1: einen Querschnitt durch eine erfindungsgemäße Steckerleistenverbindung und
- Figur 2: eine perspektivische Darstellung einer erfindungsgemäßen Steckerleistenverbin- dung.

### Ausführungsformen der Erfindung

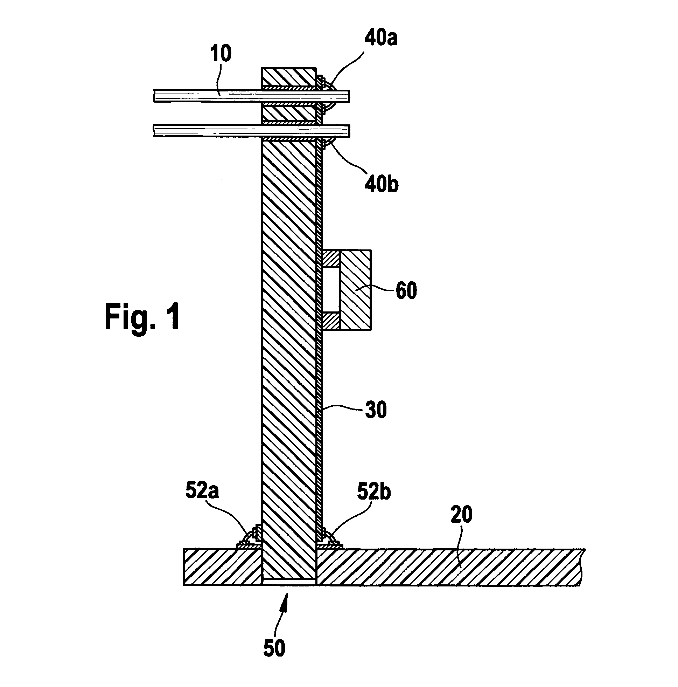

In der Figur 1 ist eine Steckerleistenverbindung im Querschnitt dargestellt, die eine Steckverbinderleiste 10, eine Hauptleiterplatte 20 sowie eine Zwischenleiterplatte 30 umfasst. Die Steckverbinderleiste 10 ist beispielsweise zweireihig aufgebaut, wobei in der Querschnittsdarstellung von Figur 1 nur ein Einzel-Steckverbindungselement einer oberen Reihe und ein Einzel-Steckverbindungselement einer unteren Reihe dargestellt ist. Die Einzel-Steckverbindungselemente, die die Steckverbinderleiste 10 bilden, sind in eine Zwischenleiterplatte 30 eingesteckt, die somit die Steckverbinderleiste 10 mit der Hauptleiterplatte 20 verbindet. Auf einer Seite des oberen Abschnitts der Zwischenleiterplatte 30 sind elektrische Verbindungen 40a, b vorgesehen, die durch Kontaktflächen auf der Zwischenleiterplatte 30 und durch eine Lötverbindung die Einzel-Steckverbindungselemente der Steckverbinderleiste 10 mit der Zwischenleiterplatte 30 verbindet. Die Steckverbinderleiste 10 umfasst ferner Verbindungen, die den oberen Abschnitt mit einem unteren Abschnitt der Zwischenleiterplatte 30 verbinden. Im unteren Abschnitt ist die Steckverbinderleiste 10 in die Hauptleiterplatte 20 eingesteckt, wobei die Hauptleiterplatte 20 einen Schlitz 50 aufweist, der mit einem Ende der Zwischenleiterplatte 30 einen Presssitz bildet. Zur elektrischen bzw. zur weiteren mechanischen Verbindung sind auch an dem unteren Abschnitt der Zwischenleiterplatte 30 Kontakte 52a, b vorgesehen, die über Leiterschichten der Zwischenleiterplatte 30 und der Hauptleiterplatte 20 sowie über Lötverbindungen (im Umriss dargestellt) die Zwischenleiterplatte 30 elektrisch sowie mechanisch mit der Hauptleiterplatte 20 verbinden. Die Zwischenleiterplatte 30 trägt ferner beispielsweise ein Bauelement 60, das beispielsweise der EMV-Filterung dient, welches mit Verbindungen (nicht dargestellt) in Kontakt steht, die die Kontaktstellen 40a, b mit den Kontaktstellen 52a, 52b verbinden. Die Zwischenleiterplatte 30 trägt somit vorzugsweise Verbindungselemente, die jedes einzelne Einzel-Steckverbindungselement mit einem Anschluss (nicht dargestellt) der Hauptleiterplatte 20 verbindet. Somit kann über die Hauptleiterplatte 20 jedes Einzel-Steckverbindungselement einzeln elektrisch kontaktiert werden.

Die Steckverbindungselemente erstrecken sich in der Figur 1 waagerecht von der Zwischenleiterplatte 30 ausgehend nach links, und stehen senkrecht zu einer Ebene, in der die Zwischenleiterplatte 30 verläuft. Die Ebene, in der die Zwischenleiterplatte 30 verläuft, ist wiederum senkrecht zu der Hauptleiterplatte 20. Bevorzugt ist eine Winkelung zwischen Hauptleiterplatte 20, Zwischenleiterplatte 30 und Erstreckungsrichtung der Steckverbindungselemente von jeweils 90°, wobei jedoch auch andere Winkel eingenommen werden können, die vorzugsweise zwischen Hauptleiterplatte 20 und Zwischenleiterplatte 30 sowie zwischen Zwischenleiterplatte 30 und Steckverbindungselementen gleich sind.

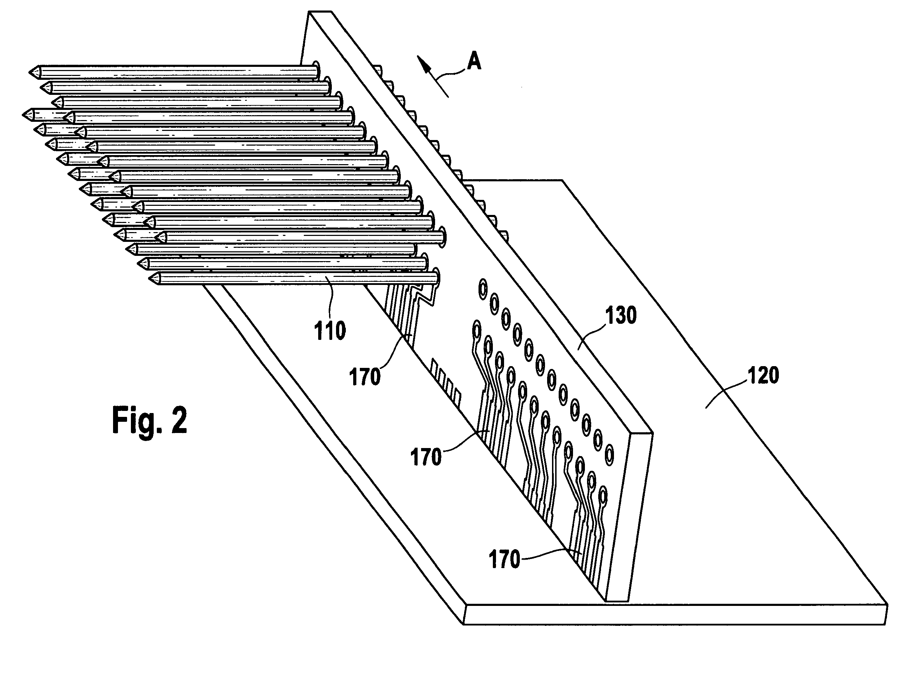

In der Figur 2 ist eine perspektivische Ansicht einer erfindungsgemäßen Steckerleistenverbindung dargestellt, mit einer Hauptleiterplatte 120 und einer dazu senkrecht abgewinkelten Zwischenleiterplatte 130, in denen senkrecht Einzel-Steckverbindungselemente eingesteckt sind. Die Steckverbindungselemente erstrecken sich somit in einer Richtung, die parallel zu der Hauptleiterplatte 120 verläuft. Die Einzel-Steckverbindungselemente sind in einer Längsrichtung gruppiert, in der sich die gesamte Steckverbinderleiste 110 erstreckt, wobei die Erstreckungsrichtung A der Steckverbinderleiste 110 parallel zur Zwischenleiterplatte 130 und parallel zur Hauptleiterplatte 120 verläuft. Die Erstreckungsrichtung der Steckverbinderleiste 110 (d. h. der Gruppierung der Einzel-Steckverbindungselemente) ist somit senkrecht zu der Erstreckungsrichtung der Einzel-Steckverbindungselemente.

Die Figur 2 zeigt ferner Leiterbahnen 170, die Kontaktflächen der Zwischenleiterplatte 130, welche die Zwischenleiterplatte 130 mit der Steckverbinderleiste 110 verbinden, an einem unteren Abschnitt der Zwischenleiterplatte 130 mit entsprechenden Kontakten (nicht dargestellt) der Hauptleiterplatte 120 verbinden. Die Zwischenleiterplatte 130 umfasst Durchgangslöcher, die zumindest auf einer Seite der Zwischenleiterplatte 130 mit einer kreisförmigen Kontaktfläche ausgebildet sind, wobei die Durchgangslöcher ferner vorzugsweise eine zylinderförmige Metallsschicht innerhalb der Zwischenleiterplatte 130 aufweisen, die sich senkrecht durch die Zwischenleiterplatte 130 hindurch erstreckt. Die innerhalb der Zwischenleiterplatte 130 und um die einzelnen Einzel-Steckverbindungselemente vorgesehenen Kontaktflächen dienen zur elektrischen Kontaktierung der Steckverbindungselemente sowie zur Befestigung der Steckverbindungselemente mit der Zwischenleiterplatte 130. Die Kontaktflächen sind wiederum über die Leiterbahn 170 elektrisch mit der Hauptleiterplatte 120 verbunden, so dass Anschlüsse der Hauptleiterplatte 120 eine elektrische Durchkontaktierung zu den einzelnen Steckverbindungselementen ermöglichen.

Die Abmessungen der dargestellten Steckerleistenverbindung sind nicht maßstäblich, insbesondere können die einzelnen Dicken der Hauptleiterplatten 120 ein anderes Verhältnis zu den Längs- bzw. Querabmessungen anderer Komponenten der Steckerleistenverbindung aufweisen als dargestellt.

Im Gegensatz zu der Figur 1, in der die Zwischenleiterplatte 130 in einen Schlitz der Hauptleiterplatte eingesteckt ist, ist die Zwischenleiterplatte 130 an einem Ende mit der Oberfläche der Hauptleiterplatte 120 verbunden, ohne dass sich die Zwischenleiterplatte 130 in die Hauptleiterplatte 120 hinein erstreckt.

## Patentansprüche

1. Steckerleistenverbindung, umfassend: eine Steckverbinderleiste (10; 110), eine Hauptleiterplatte (20; 120) mit Anschlüssen und eine Zwischenleiterplatte (30; 130), wobei die Steckverbinderleiste (10; 110) eine Gruppe Einzel-Steckverbindungselemente umfasst, die sich gewinkelt zu der Zwischenleiterplatte (30; 130) erstrecken und an dieser befestigt sind, sich die Zwischenleiterplatte (30; 130) gewinkelt zu der Hauptleiterplatte (20; 120) erstreckt und an dieser befestigt ist, und die Einzel-Steckverbindungselemente über die Zwischenleiterplatte (30; 130) elektrisch mit den Anschlüssen verbunden sind.

2. Steckerleistenverbindung nach Anspruch 1, wobei sich die Steckverbinderleiste (10, 110), die Hauptleiterplatte (20; 120) und die Zwischenleiterplatte (30; 130) längs in die gleiche Richtung A erstrecken, die parallel zur Hauptleiterplatte (20; 120) und parallel zur Zwischenleiterplatte (30; 130) ist.

3. Steckerleistenverbindung nach Anspruch 1 oder 2, wobei sich die Einzel-Steckverbindungselemente durch die Zwischenleiterplatte (30; 130) hindurch erstrecken und mit mindestens einer Leiterschicht der Zwischenleiterplatte (30; 130) durch Lötverbindungen (40a,b), Einpressverbindungen, oder andere elektrische Verbindungen mit den Einzel-Steckverbindungselementen elektrisch leitend verbunden sind.

4. Steckerleistenverbindung nach einem der vorangehenden Ansprüche, wobei die Zwischenleiterplatte (30; 130) mindestens eine Leiterschicht aufweist, die in Leiterbahnen (170) strukturiert ist, die elektrische Verbindungselemente zum Anschluss der Hauptleiterplatte (20; 120), Kontaktpads, Lötverbindungen (52a,b) oder elektrisch verbindende Steckverbindungen zum Anschluss der Hauptleiterplatte (20, 120), oder Kontaktpads, Lötverbindungen oder elektrisch verbindende Steckverbindungen zum Anschluss von Bauteilen (60) aufweisen, die mittels SMD-Technik, Durchsteck-Technik oder durch Aufstecken mit der Zwischenleiterplatte (30; 130) elektrisch verbunden sind, auf der Zwischenleiterplatte (30; 130) vorgesehen sind, und elektrische oder elektronische Bauteile sind, die aktive oder passive Bauelemente umfassen.

5. Steckerleistenverbindung nach einem der vorangehenden Ansprüche, wobei die Zwischenleiterplatte (30; 130) in mindestens zwei Segmente aufgeteilt ist, die körperlich voneinander getrennt sind und die nur über die Hauptleiterplatte (20; 120) oder über die Einzel-Steckverbindungselemente mechanisch miteinander verbunden sind.

6. Steckerleistenverbindung nach einem der vorangehenden Ansprüche, wobei die Hauptleiterplatte (20; 120) mindestens einen Schlitz (50) aufweist, in den die Zwischenleiterplatte (30; 130) eingesteckt ist und über den die Zwischenleiterplatte (30; 130) an der Hauptleiterplatte (20; 120) befestigt ist, wobei die Zwischenleiterplatte (30; 130) an dem Schlitz Lötverbindungen aufweist, die die Zwischenleiterplatte (30; 130) mit der Hauptleiterplatte (20; 120) verbinden, und die Zwischenleiterplatte (30; 130) und/oder die Hauptleiterplatte (20; 120) Anschläge, Führungselemente, Rastelemente oder eine Kombination hiervon aufweist bzw. aufweisen, über die die Zwischenleiterplatte (30; 130) mechanisch an der Hauptleiterplatte (20; 120) befestigt ist.

7. Steckerleistenverbindung nach einem der vorangehenden Ansprüche, wobei die Steckverbinderleiste (10; 110) eine Messerleiste, Federleiste, Wannensteckerleiste oder Pfostensteckerleiste umfasst, die als Steckerleiste, Verbinderleiste oder Buchsenleiste ausgeführt ist, die von den Einzel-Steckverbindungselementen vorgesehen werden, wobei die Einzel-Steckverbindungselementen als Stiftelemente, Verbinderelemente oder Buchsenelemente ausgeführt sind.

8. Verfahren zur Herstellung einer Steckerleistenverbindung, umfassend:
Vorsehen einer Steckverbinderleiste (10; 110), einer Hauptleiterplatte (20; 120) mit Anschlüssen, und einer Zwischenleiterplatte (30; 130);
Anordnen einer Gruppe von Einzel-Steckverbindungselementen als Steckverbinderleiste (10; 110);
Befestigen der Steckverbinderleiste (10; 110) an der Zwischenleiterplatte (30; 130), wobei sich Einzel-Steckverbindungselemente abgewinkelt zu der Zwischenleiterplatte (30; 130) erstrecken;
Erstellen elektrischer Kontakte zwischen der Zwischenleiterplatte (30; 130) und der Steckverbinderleiste (10; 110);
Befestigen der Zwischenleiterplatte (30; 130) an der Hauptleiterplatte (20; 120), wobei sich die Zwischenleiterplatte (30; 130) abgewinkelt zu der Hauptleiterplatte (20; 120) erstreckt; und
Erstellen elektrischer Kontakte zwischen der Hauptleiterplatte (20; 120) und der Zwischenleiterplatte (30; 130).

9. Verfahren nach Anspruch 8, das ferner umfasst: Erstellen von Lötverbindungen durch Verlöten der Steckverbinderleiste (10; 110) mit der Zwischenleiterplatte (30; 130) oder Erstellen von Einpressverbindungen durch Einpressen der Steckverbinderleiste (10; 110) in Durchgänge der Zwischenleiterplatte (30; 130) oder mittels eines Single-Pin-Insertion-Verfahrens, bei dem die Einzel-Steckverbindungselemente einzeln in die Zwischenleiterplatte (30; 130) eingepresst werden, wobei die elektrischen Kontakte zwischen einer Leiterschicht der Zwischenleiterplatte (30; 130) und den Einzel-Steckverbindungselementen vorgesehen werden;
Erstellen von Lötverbindungen durch Verlöten mindestens einer Leiterschicht, die von der Zwischenleiterplatte (30; 130) vorgesehen wird, mit mindestens einer Leiterschicht, die von der Hauptleiterplatte (20; 120) vorgesehen wird; oder
Einstecken der Zwischenleiterplatte (30; 130) in mindestens einen Schlitz (50), der in der Hauptleiterplatte (20; 120) vorgesehen ist, wobei das Einstecken der Zwischenleiterplatte (30; 130) eine mechanische, eine elektrische oder eine elektromechanische Verbindung zwischen der Zwischenleiterplatte (30; 130) und der Hauptleiterplatte (20; 120) erzeugt.

10. Verfahren nach Anspruch 8 oder 9, das ferner umfasst: mechanisches Verbinden von Einzel-Steckverbindungselementen der Steckverbinderleiste (10; 110) durch Umspritzen mit einem Isolationsmaterial, durch Einschießen der Einzel-Steckverbindungselemente der Steckverbinderleiste (10; 110) in das Isolationsmaterial, durch Aufstecken oder Aufschieben von Isolationsmaterial auf die Einzel-Steckverbindungselemente der Steckverbinderleiste (10; 110), wobei Isolationsmaterial einen Steckerkragen oder einen Steckerkörper oder beides in einteiliger oder mehrteiliger Form ausbildet.

## Claims

1. Male connector strip connection, comprising: a plug-type connector strip (10; 110), a main printed circuit board (20; 120) with terminals and an intermediate printed circuit board (30; 130), wherein the plug-type connector strip (10; 110) comprises a group of individual plug-type connection elements, which extend at an angle to the intermediate printed circuit board (30; 130) and are fastened thereto, the intermediate printed circuit board (30; 130) extends at an angle to the main printed circuit board (20; 120) and is fastened thereto, and the individual plug-type connection elements are electrically connected to the terminals via the intermediate printed circuit board (30; 130).

2. Male connector strip connection according to Claim 1, wherein the plug-type connector strip (10; 110), the main printed circuit board (20; 120) and the intermediate printed circuit board (30; 130) extend longitudinally in the same direction A which is parallel to the main printed circuit board (20; 120) and parallel to the intermediate printed circuit board (30; 130).

3. Male connector strip connection according to Claim 1 or 2, wherein the individual plug-type connection elements extend through the intermediate printed circuit board (30; 130) and are electrically conductively connected to at least one conductor layer of the intermediate printed circuit board (30; 130) by soldered connections (40a, b), press-in connections, or other electrical connections.

4. Male connector strip connection according to one of the preceding claims, wherein the intermediate printed circuit board (30; 130) has at least one conductor layer, which is patterned with conductor tracks (170), which have electrical connection elements for connecting the main printed circuit board (20; 120), contact pads, soldered connections (52a, b) or electrically connecting plug-type connections for connecting the main printed circuit board (20, 120), or contact pads, soldered connections or electrically connecting plug-type connections for connecting component parts (60) which are electrically connected to the intermediate printed circuit board (30; 130) by means of SMD technology, plug-through technology or by virtue of being plugged on, are provided on the intermediate printed circuit board (30; 130), and are electrical or electronic component parts which comprise active or passive components.

5. Male connector strip connection according to one of the preceding claims, wherein the intermediate printed circuit board (30; 130) is divided into at least two segments, which are physically separated from one another and which are mechanically connected to one another only via the main printed circuit board (20; 120) or via the individual plug-type connection elements.

6. Male connector strip connection according to one of the preceding claims, wherein the main printed circuit board (20; 120) has at least one slot (50), into which the intermediate printed circuit board (30; 130) is plugged and via which the intermediate printed circuit board (30; 130) is fastened to the main printed circuit board (20; 120), wherein the intermediate printed circuit board (30; 130) has soldered connections at the slot, said soldered connections connecting the intermediate printed circuit board (30; 130) to the main printed circuit board (20; 120), and the intermediate printed circuit board (30; 130) and/or the main printed circuit board (20; 120) has or have stops, guide elements, latching elements or a combination thereof, via which the intermediate printed circuit board (30; 130) is fastened mechanically to the main printed circuit board (20; 120).

7. Male connector strip connection according to one of the preceding claims, wherein the plug-type connector strip (10; 110) comprises a male multipoint connector, a female multipoint connector, a trough-type connector strip or post-type connector strip, which is in the form of a male connector strip, a connector strip or a female connector strip, which are provided by the individual plug-type connection elements, wherein the individual plug-type connection elements are in the form of pin elements, connector elements or socket elements.

8. Method for producing a male connector strip connection, comprising:
providing a plug-type connector strip (10; 110), a main printed circuit board (20; 120) with terminals, and an intermediate printed circuit board (30; 130);
arranging a group of individual plug-type connection elements as plug-type connector strip (10; 110);
fastening the plug-type connector strip (10; 110) to the intermediate printed circuit board (30; 130),
wherein individual plug-type connection elements extend so as to be bent back at an angle with respect to the intermediate printed circuit board (30; 130);
providing electrical contacts between the intermediate printed circuit board (30; 130) and the plug-type connector strip (10; 110);
fastening the intermediate printed circuit board (30; 130) to the main printed circuit board (20; 120), wherein the intermediate printed circuit board (30; 130) extends so as to be bent back at an angle with respect to the main printed circuit board (20; 120); and
providing electrical contacts between the main printed circuit board (20; 120) and the intermediate printed circuit board (30; 130).

9. Method according to Claim 8, which further comprises: providing soldered connections by soldering the plug-type connector strip (10; 110) to the intermediate printed circuit board (30; 130) or providing press-in connections by pressing the plug-type connector strip (10; 110) into passages in the intermediate printed circuit board (30; 130) or by means of a single-pin insertion method, in which the individual plug-type connection elements are pressed individually into the intermediate printed circuit board (30; 130), wherein the electrical contacts are provided between a conductor layer of the intermediate printed circuit board (30; 130) and the individual plug-type connection elements;
providing soldered connections by soldering at least one conductor layer, which is provided by the intermediate printed circuit board (30; 130), to at least one conductor layer, which is provided by the main printed circuit board (20; 120); or
plugging the intermediate printed circuit board (30; 130) into at least one slot (50), which is provided in the main printed circuit board (20; 120), wherein the process of plugging in the intermediate printed circuit board (30; 130) produces a mechanical, electrical or electromechanical connection between the intermediate printed circuit board (30; 130) and the main printed circuit board (20; 120).

10. Method according to Claim 8 or 9, which further comprises: mechanically connecting individual plug-type connection elements of the plug-type connector strip (10; 110) by virtue of encapsulation by injection moulding with an insulating material, by virtue of injecting the individual plug-type connection elements of the plug-type connector strip (10; 110) into the insulating material, by virtue of plugging or pushing insulating material onto the individual plug-type connection elements of the plug-type connector strip (10; 110), wherein insulating material forms a male connector skirt or a male connector body or both in single-part or multi-part form.

## Revendications

1. Liaison par barrette enfichable comprenant :
une barrette de connexion à enficher (10 ; 110), un circuit imprimé principal (20 ; 120) muni de bornes et un circuit imprimé intermédiaire (30 ; 130), la barrette de connexion à enficher (10 ; 110) comprenant un groupe d'éléments de liaison à enficher individuels qui s'étendent de manière coudée par rapport au circuit imprimé intermédiaire (30 ; 130) et qui sont fixés à celui-ci, le circuit imprimé intermédiaire (30 ; 130) s'étendant de manière coudée par rapport au circuit imprimé principal (20 ; 120) et étant fixé à celui-ci et les éléments de liaison à enficher individuels étant reliés électriquement avec les bornes par le biais du circuit imprimé intermédiaire (30 ; 130).

2. Liaison par barrette enfichable selon la revendication 1, avec laquelle la barrette de connexion à enficher (10 ; 110), le circuit imprimé principal (20 ; 120) et le circuit imprimé intermédiaire (30 ; 130) s'étendent en longueur dans la même direction A, laquelle est parallèle au circuit imprimé principal (20 ; 120) et au circuit imprimé intermédiaire (30 ; 130).

3. Liaison par barrette enfichable selon la revendication 1 ou 2, avec laquelle les éléments de liaison à enficher individuels s'étendent à travers le circuit imprimé intermédiaire (30 ; 130) et sont reliés de manière électriquement conductrice avec au moins une couche conductrice du circuit imprimé intermédiaire (30 ; 130) par des liaisons brasées (40a, b), des liaisons à enfoncement ou d'autres liaisons électriques.

4. Liaison par barrette enfichable selon l'une des revendications précédentes, avec laquelle le circuit imprimé intermédiaire (30 ; 130) présente au moins une couche conductrice qui est structurée en pistes conductrices (170), lesquelles présentent des éléments de liaison électrique pour le raccordement du circuit imprimé principal (20 ; 120), des pastilles de contact, des liaisons brasées (52a, b) ou des liaisons à enficher de connexion électrique pour le raccordement du circuit imprimé principal (20 ; 120), ou des pastilles de contact, des liaisons brasées ou des liaisons à enficher de connexion électrique pour le raccordement de composants (60), lesquels sont reliés électriquement au moyen d'une technique CMS, d'une technique de traversée ou par enfichage avec le circuit imprimé intermédiaire (30 ; 130), lesquels son prévus sur le circuit imprimé intermédiaire (30 ; 130) et lesquels sont des composants électriques ou électroniques qui incluent des éléments actifs ou passifs.

5. Liaison par barrette enfichable selon l'une des revendications précédentes, avec laquelle le circuit imprimé intermédiaire (30 ; 130) est divisé en au moins deux segments qui sont séparés physiquement l'un de l'autre et qui sont reliés mécaniquement entre eux uniquement par le biais du circuit imprimé principal (20 ; 120) ou par le biais des éléments de liaison à enficher individuels.

6. Liaison par barrette enfichable selon l'une des revendications précédentes, avec laquelle le circuit imprimé principal (20 ; 120) présente au moins une fente (50) dans laquelle est inséré le circuit imprimé intermédiaire (30 ; 130) et par le biais de laquelle le circuit imprimé intermédiaire (30 ; 130) est fixé au circuit imprimé principal (20 ; 120), avec laquelle le circuit imprimé intermédiaire (30 ; 130) présente au niveau de la fente des liaisons brasées qui relient le circuit imprimé intermédiaire (30 ; 130) avec le circuit imprimé principal (20 ; 120) et le circuit imprimé intermédiaire (30 ; 130) et/ou le circuit imprimé principal (20 ; 120) présente ou présentent des butées, des éléments de guidage, des éléments d'encliquetage ou une combinaison de ceux-ci, par le biais desquels le circuit imprimé intermédiaire (30 ; 130) est fixé mécaniquement au circuit imprimé principal (20 ; 120).

7. Liaison par barrette enfichable selon l'une des revendications précédentes, avec laquelle la barrette de connexion à enficher (10 ; 110) comprend une barrette de lames, une barrette de ressorts, une barrette enfichable de tulipes ou une barrette enfichable de picots, laquelle est réalisée sous la forme d'une barrette enfichable, d'une barrette de connexion ou d'une barrette à douilles, lesquelles sont prévues par les éléments de liaison à enficher individuels, avec laquelle les éléments de liaison à enficher individuels sont réalisés sous la forme d'éléments à picots, d'éléments de connexion ou d'éléments à douille.

8. Procédé de fabrication d'une liaison par barrette enfichable comprenant :
Présentation d'un barrette de connexion à enficher (10 ; 110), d'un circuit imprimé principal (20 ; 120) muni de bornes et d'un circuit imprimé intermédiaire (30 ; 130) ;
Arrangement d'un groupe d'éléments de liaison à enficher individuels sous la forme d'une barrette de connexion à enficher (10 ; 110) ;
Fixation de la barrette de connexion à enficher (10 ; 110) sur le circuit imprimé intermédiaire (30 ; 130), les éléments de liaison à enficher individuels s'étendant de manière coudée par rapport au circuit imprimé intermédiaire (30 ; 130) ;
Établissement de contacts électriques entre le circuit imprimé intermédiaire (30 ; 130) et la barrette de connexion à enficher (10 ; 110) ;
Fixation du circuit imprimé intermédiaire (30 ; 130) au circuit imprimé principal (20 ; 120), le circuit imprimé intermédiaire (30 ; 130) s'étendant de manière coudée par rapport au circuit imprimé principal (20 ; 120) ; et
Établissement de contacts électriques entre le circuit imprimé principal (20 ; 120) et le circuit imprimé intermédiaire (30 ; 130).

9. Procédé selon la revendication 8, lequel comprend en outre : Établissement de liaisons brasées en brasant la barrette de connexion à enficher (10 ; 110) avec le circuit imprimé intermédiaire (30 ; 130) ou Établissement de liaisons à enfoncement en enfonçant la barrette de connexion à enficher (10 ; 110) dans des passages du circuit imprimé intermédiaire (30 ; 130) ou au moyen d'un procédé par insertion d'une broche unique lors duquel les éléments de liaison à enficher individuels sont enfoncés individuellement dans le circuit imprimé intermédiaire (30 ; 130), les contacts électriques entre une couche conductrice du circuit imprimé intermédiaire (30 ; 130) et les éléments de liaison à enficher individuels étant prévus ; Établissement de liaisons brasées en brasant au moins une couche conductrice qui est prévue par le circuit imprimé intermédiaire (30 ; 130) avec au moins une couche conductrice qui est prévue par le circuit imprimé principal (20 ; 120) ; ou
Insertion du circuit imprimé intermédiaire (30 ; 130) dans au moins une fente (50) qui est prévue dans le circuit imprimé principal (20 ; 120), l'insertion du circuit imprimé intermédiaire (30 ; 130) produisant une liaison mécanique, électrique ou électromécanique entre le circuit imprimé intermédiaire (30 ; 130) et le circuit imprimé principal (20 ; 120).

10. Procédé selon la revendication 8 ou 9, lequel comprend en outre : Liaison mécanique des éléments de liaison à enficher individuels de la barrette de connexion à enficher (10 ; 110) par surmoulage avec un matériau isolant, par insertion des éléments de liaison à enficher individuels de la barrette de connexion à enficher (10 ; 110) dans le matériau isolant, par enfichage ou enfilement du matériau isolant sur les éléments de liaison à enficher individuels de la barrette de connexion à enficher (10 ; 110), le matériau isolant formant un collet de fiche ou un corps de fiche ou les deux dans une forme en une partie ou en plusieurs parties.
